# EUROPÄISCHE PATENTSCHRIFT

(11) **EP 1 747 588 B1**
(45) Veröffentlichungstag und Bekanntmachung des Hinweises auf die Patenterteilung: **21.11.2007**
(21) Anmeldenummer: 05732275.2
(22) Anmeldetag: 22.04.2005
(51) Int. Cl.: H01L 31/112, H01L 31/0203

(54) **BELEUCHTBARES GaAs-SCHALTBAUTEIL MIT TRANSPARENTEM GEHÄUSE UND MIKROWELLENSCHALTUNG HIERMIT**
ILLUMINABLE GAAS SWITCHING COMPONENT WITH A TRANSPARENT HOUSING, AND MICROWAVE CIRCUIT THEREWITH
COMPOSANT ECLAIRABLE DE COMMUTATION EN GAAS A BOITIER TRANSPARENT ET CIRCUIT A MICRO-ONDES COMPRENANT CE COMPOSANT

(30) Priorität: 17.05.2004 DE 102004024368
(43) Veröffentlichungstag der Anmeldung: 31.01.2007
(73) Patentinhaber: Rohde & Schwarz GmbH & Co. KG, 81671 München (DE)
(72) Erfinder: KRAEMER, Wilhelm, 83435 Bad Reichenhall (DE)
(74) Vertreter: Körfer, Thomas
(86) Internationale Anmeldenummer: PCT/EP2005/004332
(87) Internationale Veröffentlichungsnummer: WO 2005/114737

(56) Entgegenhaltungen:
- EP-A- 0 348 361
- DE-B- 1 299 087
- US-A- 4 394 572
- US-A1- 2004 036 462
- US-B1- 6 420 205
- US-B1- 6 440 778
- SIMONS R N ET AL: "ANALYSIS OF OPTICALLY CONTROLLED MICROWAVE/MILLIMETER-WAVE DEVICE STRUCTURES" IEEE TRANSACTIONS ON MICROWAVE THEORY AND TECHNIQUES, IEEE SERVICE CENTER, PISCATAWAY, NJ, US, Bd. MTT-34, Nr. 12, 1. Dezember 1986 (1986-12-01), Seiten 1349-1355, XP000111727 ISSN: 0018-9480
- SUN C K ET AL: "Photovoltaic-FET for Optoelectronic RF/<maths><tex>$\mbi{\mu}$</tex>< /maths>wave Switching" IEEE TRANSACTIONS ON MICROWAVE THEORY AND TECHNIQUES, IEEE SERVICE CENTER, PISCATAWAY, NJ, US, Bd. 44, Nr. 10, Oktober 1996 (1996-10), XP011036588 ISSN: 0018-9480

## Beschreibung

Die Erfindung betrifft ein elektronisches Schaltbauteil mit Feldeffekt-Transistoren auf einer Subtratbasis aus Galium-Arsenid, das insbesondere aber nicht ausschließlich zum schnellen Schalten hochfrequenter Signale in Mikrowellen-Dämpfungsschaltungen verwendet wird und welches durch eine Lichtquelle bestrahlt werden kann, wobei das dabei auf die Feldeffekt-Transistoren auftreffende Licht insbesondere die Schaltzeiten der Feldeffekt-Transistoren bzw. des elektronischen Schaltbauteils wesentlich verkürzen kann.

Feldeffekt-Transistoren lassen sich bekanntermaßen sehr leicht auf einem Halbleiterchip realisieren. Darüber hinaus benötigen sie nur sehr wenig Steuerleistung. Eine Belichtung von Feldeffekt-Transistoren auf Galium-Arsenid-Basis, insbesondere von MESFET, hat zu Folge, daß Störstellen, welche an den Halbleitergrenzflächen insbesondere unterhalb der Gate-Elektrode auftreten und negativen Einfluß auf die Schaltzeiten der Feldeffekt-Transistoren haben, schneller umgeladen werden. Der negative Einfluß der Störstellen ist bei MESFET-Bauelementen als Gate-Lag-Effekt bekannt und wird als äußerst langsame Änderung des Bahnwiderstandes meßbar. Ursache ist die langsame Auf- bzw. Entladung der Oberflächenstörstellen der Source-Gate-Strecke und der Gate-Drain-Strecke. Durch die Beleuchtung der Feldeffekt-Transistoren werden Elektronen-Loch-Paare erzeugt, welche die in den Störstellen gefangenen Ladungen neutralisieren. Durch die Beleuchtung läßt sich der Gate-Lag-Effekt unterdrücken und die Schaltzeit um den Faktor 10 - 100 verkürzen.

Hochfrequenz-Schaltungen, beispielsweise Mikrowellen-Schaltungen, die als Dämpfungsschaltungen ausgeführt sind, werden z.B. in der Hochfrequenztechnik für Meßzwecke, z. B. zur Pegelregelung in Signalgeneratoren und Netzwerkanalysatoren eingesetzt. Um beispielsweise Meßreihen mit verschiedenen veränderlichen Parametern schnell durchfahren zu können, müssen die Dämpfungsschaltungen bzw. die in ihnen zum Einsatz kommenden Schaltbauteile sehr schnell schalten können und einen großen Dynamikbereich aufweisen. Dabei werden insbesondere wegen ihrer ausgezeichneten Hochfrequenztauglichkeit und ihrer sehr geringen Schaltzeiten Schaltungen mit Feldeffekt-Transistoren auf Galium-Arsenid-Basis verwendet, die in neueren Schaltungsanordungen insbesondere zur weiteren Schaltzeitverkürzung zudem beleuchtbar sind.

Aus der DE 102 28 810 A1 ist eine gattungsgemäße Mikrowellen-Schaltung bekannt. Das dort offenbarte digital ansteuerbare Dämpfungsglied ist mit Feldeffekt-Transistoren als Schaltelementen aufgebaut, die beispielsweise durch eine LED beleuchtbar sind. Die Schaltung aus Feldeffekt-Transistoren ist dabei auf einem ungehäusten Halbleiterchip aus Galium-Arsenid aufgebaut, wobei der Halbleiterchip auf einem Substrat mit einer aufwendigen und teueren Hybrid-Technik befestigt ist und mit dem Substrat durch elektrische Anschlüsse verbunden ist. Der Halbleiterchip besitzt kein eigenes Gehäuse, da das Licht der Lichtquelle auf die Feldeffekt-Transistoren treffen soll. Die in der oben genannten Druckschrift offenbarte Mikrowellen-Schaltung ist deshalb aufwendig mit einem luftdichten Gehäuse umgeben.

Nachteilig bei dem aus der DE 102 28 810 A1 hervorgehenden elektronischen Schaltbauteil mit Feldeffekt-Transistoren auf einer Subtratbasis aus Galium-Arsenid ist, daß zum Befestigen und Kontaktieren des Schaltbauteils in einer Schaltung eine aufwendige, teuere und empfindliche Montagetechnik, sog. Hybrid-Technik, verwendet werden muß, da das Schaltbauteil nicht über ein eigenes Gehäuse verfügt, welches beispielsweise über eigene nach außen führende Kontaktanschlüsse (Pins) verfügt. Um das empfindliche offene Schaltbauteil, bzw. die Halbleiterübergänge oder Metall-Halbleiter-Übergänge, vor Umwelteinflüssen und Schmutzpartikel zu schützen, welche beispielsweise Abschattungen auf einem Halbleiterübergang bewirken können, ist das Schaltbauteil und das Substrat auf dem das Schaltbauteil montiert ist überdies mit einem luftdichten, großräumigen und entsprechend teueren Gehäuse umgeben.

Aus der DE 12 99 087 B ist ein in einem Gehäuse angeordneter Feldeffekt-Fototransistor mit zwei voneinander räumlich getrennten, sperrschichtfrei kontaktierten, gleichartig dotierten Bereichen in einem entgegengesetzt dotierten Halbleiterkristall bekannt, wobei auf der Oberfläche des Kristalls zumindest zwischen den beiden gleichartig dotierten Bereichen eine lichtdurchlässige elektrische Isolatorschicht und auf dieser Schicht eine weitere lichtdurchlässige, elektrisch leitende und sperrschichtfrei kontaktierte, als Steuerelektrode wirkende Schicht angeordnet ist. Nachteilig bei dem aus der DE 12 99 087 B hervorgehenden elektronischen Schaltbauteil mit Feldeffekt-Transistoren auf einer Substratbasis aus Gallium-Arsenid ist, dass das offenbarte Gehäuse des Feldeffekt-Fototransistors eine Linse aufweist, die ohne Aufnahmevorrichtung für ein Ende eines Lichtwellenleiters und/oder einer Lichtquelle in die Wandung des Gehäuses integriert ist und dabei eine Aufnahmevorrichtung darstellt, die einstückig mit dem Gehäuse ausgeführt ist. Dies führt zu einem erhöhten Justageaufwand der Lichtquelle gegenüber der Linse.

Es ist daher Aufgabe der Erfindung ein im Vergleich zum Stand der Technik zuverlässigeres, weniger fehleranfälliges, kostengünstiger herzustellendes und montierbares sowie unempfindlicheres elektronisches Schaltbauteil mit Feldeffekt-Transistoren auf einer Subtratbasis aus Galium-Arsenid aufzuzeigen, bei dem die Feldeffekt-Transistoren insbesondere zur Schaltungsbeschleunigung beleuchtbar sind.

Die Aufgabe wird erfindungsgemäß durch ein elektronisches Schaltbauteil mit den Merkmalen des Anspruchs 1 gelöst.

Erfindungsgemäß wird das elektronische Schaltbauteil mit einem eigenen Gehäuse umgeben, das zumindest einen lichtdurchlässigen Abschnitt aufweist, wobei der lichtdurchlässige Abschnitt so angeordnet ist, daß Licht von außerhalb des eigenen Gehäuses auf die Feldeffekt-Transistoren fallen oder gerichtet werden kann.

Vorteilhafte Weiterbildungen ergeben sich aus den Unteransprüchen.

Gemäß einer Weiterbildung der Erfindung werden die Feldeffekt-Transistoren als MESFET (Metall-Halbleiter-FET), die als Gate-Kanal-Übergang einen Metall-HalbleiterÜbergang ohne Oxid verwenden, insbesondere als GaAs-MESFET, also MESFET, die auf einem Gallium-Arsenid-Substrat aufgebaut sind, ausgeführt. Sie sind bekannt für ihre hervorragenden Hochfrequenzeigenschaften.

In einer weiteren Weiterbildung ist die Aufnahmevorrichtung so ausgebildet, daß nur das aus der Lichtquelle in der Aufnahmevorrichtung angeordnete bzw. dem in der Aufnahmevorrichtung aufgenommenen Ende des Lichtwellenleiters austretende Licht durch den lichtdurchlässigen Abschnitt auf die Feldeffekt-Transistoren fällt. Dadurch ist es insbesondere möglich unbeabsichtigte Schwankungen der Beleuchtungsstärke durch Fremdlicht, das nicht von den jeweils den jeweiligen Schaltbauteilen zugeordneten Lichtquellen kommt, zu vermeiden.

Durch die Ausführung des erfindungsgemäßen elektronischen Schaltbauteils als Surface Mounted Device (oberflächenmontiertes Bauelement, SMD) wird die Montagefreundlichkeit verbessert.

Vorteilhafterweise besteht der lichtdurchlässige Abschnitt aus einem lichtdurchlässigen Material, wobei das lichtdurchlässige Material insbesondere durch seine Formgebung das Licht der Lichtquelle auf die Feldeffekt-Transistoren umlenkt und/oder konzentriert. Dadurch kann bei gleicher Leistung die Lichtstärke auf den Feldeffekt-Transistoren erhöht werden. Außerdem kann die Position der Lichtquelle bzw. des Endes des Lichtwellenleiters relativ zum lichtdurchlässigen Abschnitt variabler gestaltet werden und die Feldeffekt-Transistoren werden vor Verunreinigungen und Umwelteinflüssen besser geschützt.

Vorteilhafterweise ist das eigene Gehäuse des erfindungsgemäßen elektronischen Schaltbauteils zweiteilig ausgeführt. Beispielsweise läßt sich so die Herstellung eines nur abschnittsweisen lichtdurchlässigen Gehäuses vereinfachen, wobei es besonders vorteilhaft ist, das Gehäuse zumindest aus einem ein Gehäuseunterteil bildendes erstes Gehäuseteil und einem ein Gehäuseoberteil bildenden zweiten Gehäuseteil zu fertigen. Die Herstellung des Gehäuses läßt sich durch ein vollständig lichtdurchlässiges zweites Gehäuseteil noch weiter vereinfachen.

Besteht das erste Gehäuseteil zumindest teilweise aus einem keramischen Material, lassen sich die in der Hochfrequenztechnik wichtigen dielektrischen Eigenschaften des Gehäuses erhalten.

Besteht das erste Gehäuseteil zumindest teilweise aus einem metallischen Material, läßt sich Abwärme aus dem Gehäuse besser abführen.

Die Erfindung wird nachstehend anhand schematischer Darstellungen an Ausführungsbeispielen näher erläutert. Übereinstimmende Bauteile sind dabei mit übereinstimmenden Bezugszeichen versehen. In der Zeichnung zeigen:
- Fig. 1: ein schematisch dargestelltes erstes Beispiel eines Schaltbauteils in einer Seitenansicht,
- Fig. 2: das schematisch dargestellte erste Beispiel in einer Draufsicht,
- Fig. 3: ein schematisch dargestelltes Schaltbauteil in einer Draufsicht entsprechend eines zweiten Beispiels,
- Fig. 4: ein schematisch dargestelltes erfindungsgemäßes Schaltbauteil mit einer Aufnahmevorrichtung in einer Seitenansicht entsprechend eines Ausführungsbeispiels,
- Fig. 5: ein schematisch dargestelltes Schaltbauteil in einer Draufsicht entsprechend einem dritten Beispiels,
- Fig. 6: das schematisch dargestellte dritte Beispiel in einer Seitenansicht,
- Fig. 7: ein Beispiel der Schaltung mit GaAs-Feldeffekt-Transistoren des erfindungsgemäßen Schaltbauteils,
- Fig. 8: ein schematisch dargestelltes Schaltbauteil in einer Draufsicht entsprechend einem vierten Beispiel,
- Fig. 9: das schematisch dargestellte vierte Beispiel in einer Ansicht von unten und
- Fig. 10: den schematisch dargestellten Aufbau einer Mikrowellen-Schaltung.

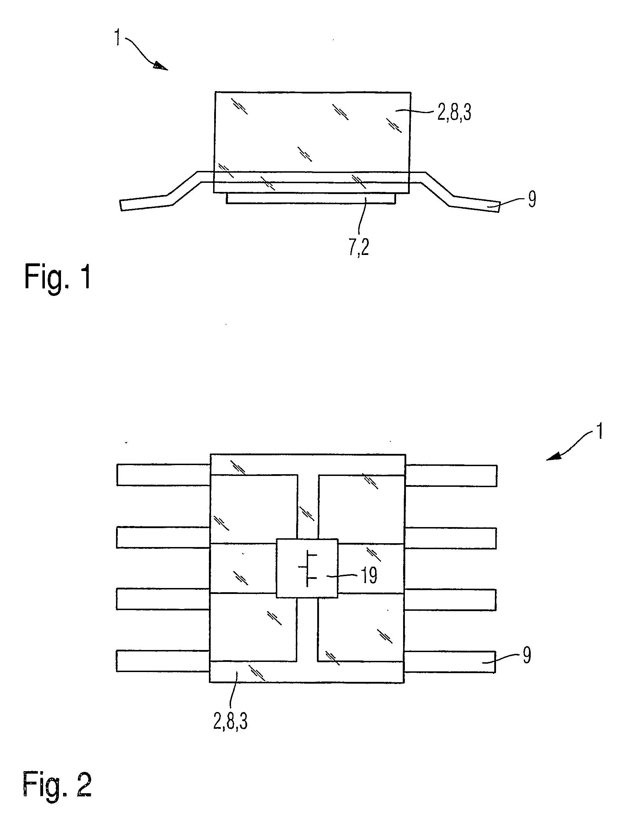

Fig. 1 zeigt ein erstes Beispiel eines elektronischen Schaltbauteils 1 in einer Seitenansicht. Das elektronische Schaltbauteil 1 weist ein eigenes Gehäuse 2 mit beispielsweise acht Kontaktanschlüssen bzw. Pins 9 auf, die auf jeweils gegenüberliegenden Seiten des rechteckigen Gehäuses 2 angeordnet sind.

Im Inneren des Gehäuses 2 befindet sich eine in Fig. 2 schematisch dargestellte Schaltung 19 mit GaAs-Feldeffekt-Transistoren (GaAs-FET) zum Schalten von elektronischen Signalen. Das Gehäuse 2 ist im gezeigten Beispiel zweiteilig ausgeführt und besteht aus einem ersten Gehäuseteil 7, welcher als Gehäuseunterteil 7 ausgeführt ist, und einem zweiten Gehäuseteil 8, welcher als Gehäuseoberteil 8 ausgeführt ist. Die Pins 9 sind führen seitlich in den ersten Gehäuseteil 7, um im Inneren des Gehäuses 2 die Schaltung mit GaAs-Feldeffekt-Transistoren zu kontaktieren. Die Schaltung 19 mit GaAs-Feldeffekt-Transistoren ist dabei beispielsweise fest mit dem ersten Gehäuseteil 7 verbunden. Das erste Gehäuseteil 7 besteht im gezeigten Beispiel aus einem lichtundurchlässigen keramischen Material mit sehr kleiner Dielektrizitätskonstante.

Das zweite Gehäuseteil 8 besteht im gezeigten Beispiel vollständig aus einem transparenten, lichtdurchlässigen Kunststoff, womit das ganze zweite Gehäuseteil 8 einen lichtdurchlässigen Abschnitt 3 bildet durch den die GaAs-Feldeffekt-Transistoren der Schaltung 19 mittels einer nicht dargestellten Lichtquelle mit Licht bestrahlt werden können. Als lichtdurchlässiger Kunststoff eignet sich insbesondere Acrylglas und Polymethlymethacrylat (PMMA).

Fig. 2 zeigt das schematisch dargestellte erste Beispiel in einer Draufsicht. Im Inneren des Gehäuses 2 ist durch den den lichtdurchlässigen Abschnitt 3 bildenden zweiten Gehäuseteil 8 die Schaltung 19 mit den GaAs-Feldeffekt-Transistoren (GaAs-FET) zum Schalten von elektronischen Signalen erkennbar. Die Schaltung 19 ist im gezeigten Beispiel auf dem ersten Gehäuseteil 7 befestigt. In anderen Ausführungsbeispielen kann das erste Gehäuseteil 7 zumindest teilweise aus einem gut wärmeleitenden Metall oder einer Metallegierung bestehen.

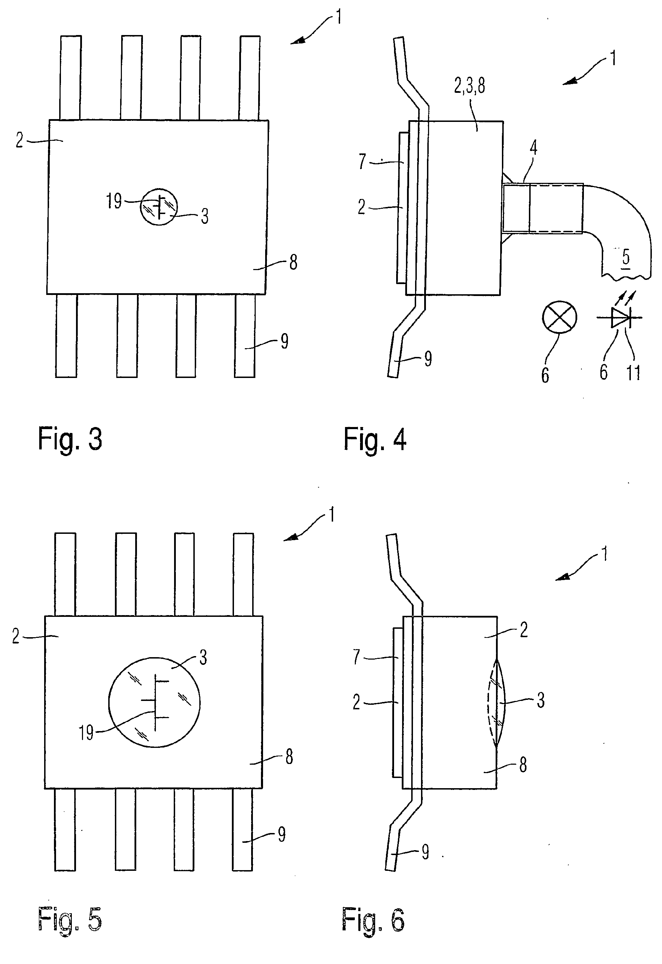

Fig. 3 zeigt das schematisch dargestellte Schaltbauteil 1 in einer Draufsicht entsprechend einem zweiten Beispiels. Das in diesem Beispiel von oben sichtbare zweite Gehäuseteil 8 besteht aus einem lichtundurchlässigen Material, vorzugsweise aus dem gleichen Material wie das in dieser Darstellung nicht sichtbare erste Gehäuseteil 7. Das durch die beiden Gehäuseteile 7 und 8 gebildete Gehäuse 2 kann in anderen Beispielen auch einteilig ausgebildet sein, beispielsweise durch ein Spritzgußverfahren. Das in diesem Beispiel durch das Gehäuseoberteil 8 gebildete zweite Gehäuseteil 8 ist bis auf einen lichtdurchlässigen Abschnitt 3 lichtundurchlässig. Das in diesem Beispiel durch das nicht dargestellte Gehäuseunterteil 7 gebildete erste Gehäuseteil 7 ist lichtundurchlässig ausgebildet. Durch den in diesem Beispiel in der Mitte der Oberseite des zweiten Gehäuseteil 8 angeordneten kreisrunden lichtdurchlässigen Abschnitt 3 kann die Schaltung 19 mit GaAs-FET bzw. die GaAs-FET selbst mit Licht beleuchtet werden. Wie in der Beschreibungseinleitung bereits erwähnt, können die Schaltzeiten der GaAs-FET dadurch erheblich reduziert werden.

Der lichtdurchlässige Abschnitt 3 kann als einfache bloße Öffnung ausgebildet sein oder aus einem lichtdurchlässigen festen Material wie z.B. Glas und/oder einem lichtdurchlässig gestalteten Kunststoff bestehen.

Fig. 4 zeigt das schematisch dargestelltes erfindungsgemäßes Schaltbauteil 1 in einer Seitenansicht mit einer Aufnahmevorrichtung 4 entsprechend eines Ausführungsbeispiels. Das in seiner äußeren Formgebung dem Gehäuse 2 aus Fig. 1 entsprechenden Gehäuse 2 weist auf der Oberseite des zweiten Gehäuseteils 8 zusätzlich die Aufnahmevorrichtung 4 zur Aufnahme eines Endes eines Lichtwellenleiters 5 und/oder einer Lichtquelle 6 auf. Die Aufnahmevorrichtung 4 ist hohlzylinderförmig ausgebildet und umringt mit seinem der Oberseite des zweiten Gehäuseteils 8 zugewandten offenen Ende den wie in Fig. 3 ausgebildeten und angeordneten lichtdurchlässigen Abschnitt 3 vollständig. Die Aufnahmevorrichtung 4 ist mit dem Gehäuse 2 beispielsweise durch ein Schmelz-, Guß- und/oder Spritzverfahren einstückig ausgeführt oder durch ein stoffschlüssiges Fügeverfahren mit dem Gehäuse 2 verbunden. Im gezeigten Ausführungsbeispiel ist die Aufnahmevorrichtung 4 so ausgeführt und ein Ende des Lichtwellenleiters 5 so in die Aufnahmevorrichtung 4 eingeführt, daß kein anderes Licht außer das aus dem Lichtwellenleiter 5 austretende Licht durch den lichtdurchlässigen Abschnitt 3 treten kann.

Das elektronische Schaltbauteil 1 ist im Ausführungsbeispiel als sog. SMD-Bauteil (Surface Mounted Device) ausgeführt.

Fig. 5 zeigt ein schematisch dargestelltes Schaltbauteil 1 in einer Draufsicht entsprechend einem dritten Beispiel. Im gezeigten Beispiel besteht der lichtdurchlässige Abschnitt 3 aus einem transparenten Kunststoff oder Glas mit optischen Eigenschaften, die der einer Sammellinse entsprechen, um das einfallende Licht zu konzentrieren. Der lichtdurchlässige Abschnitt 3 ist im Gehäuseoberteil 8 angeordnet, kann aber anderen Ausführungsbeispielen aber auch beispielsweise im Gehäuseunterteil 7 angeordnet sein. Soll der lichtdurchlässige Abschnitt 3 klein gehalten werden und ist gleichzeitig eine große Fläche der Schaltung 19 mit GaAs-FET zu beleuchten, so kann auch eine Streulinse Verwendung finden.

Fig. 6 zeigt das schematisch dargestellte dritte Beispiel in einer Seitenansicht. Der als Sammellinse ausgebildete lichtdurchlässige Abschnitt 3 sowie die zweiteilige Ausführung des Gehäuses 2 sind deutlich zu erkennen.

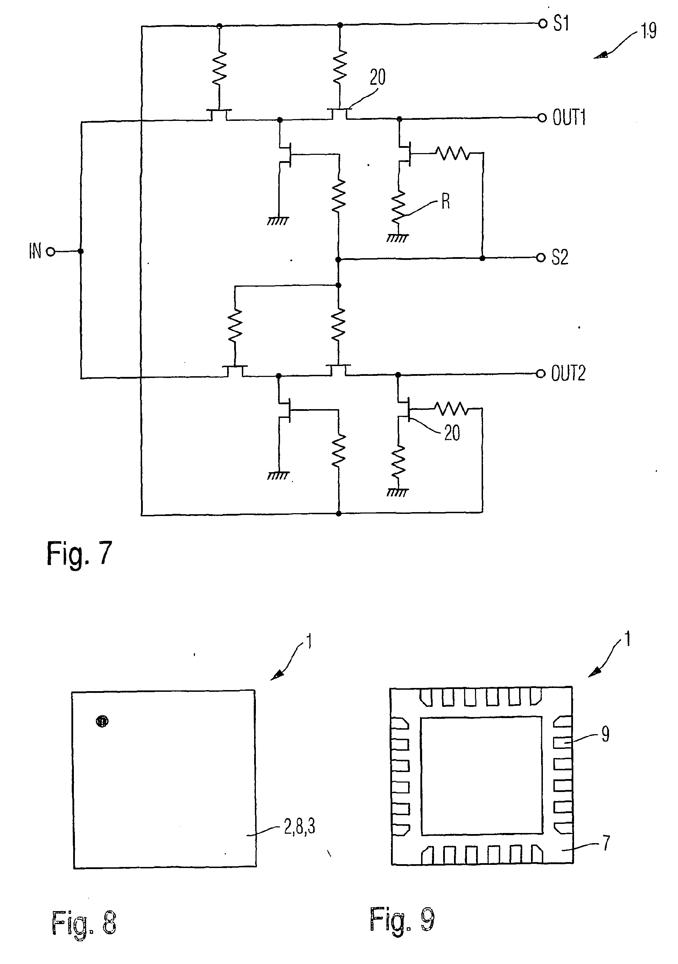

Fig. 7 zeigt ein Beispiel der Schaltung 19 mit GaAs-Feldeffekt-Transistoren des erfindungsgemäßen Schaltbauteils 1. Die Schaltung 19 weist mehrere GaAs-Feldeffekt-Transistoren 20, einen Hochfrequenzeingang IN, einen ersten Hochfrequenzausgang OUT1, einen zweiten Hochfrequenzausgang OUT2, einen ersten Steueranschluß S1, einen zweiten Steueranschluß S2 sowie mehrere Widerstände R auf. Wird am Hochfrequenzeingang IN ein elektrisches Hochfrequenzsignal angelegt, kann es durch Wahl der elektrischen Spannungen an den beiden Steueranschlüssen S1 und S2 zwischen den beiden Hochfrequenzausgängen OUT1 und OUT2 umgeschaltet werden, so daß jeweils an einem der Hochfrequenzausgängen OUT1 oder OUT2 das Hochfrequenzeingangssignal mit nur einer geringen Dämpfung ausgegeben wird. Im gezeigten Beispiel ist der Hochfrequenzausgang OUT1, OUT2, der jeweils nicht das Hochfrequenzeingangssignal ausgibt, gegen den Eingang elektrisch isoliert und gleichzeitig mit einem Abschlußwiderstand z. B. von 50 Ω abgeschlossen.

Beispielsweise wird das am Hochfrequenzeingang IN anliegende Hochfrequenzsignal bei einer Spannung von 0 Volt am ersten Steueranschluß S1 und einer Spannung von -5 Volt am zweiten Steueranschluß S2 auf den ersten Hochfrequenzausgang OUT1 mit nur einer geringen Dämpfung durch die GaAs-Feldeffekt-Transistoren 20 durchgeschaltet. Beim Vertauschen der beiden Steuerspannungen wird das Hochfrequenzeingangssignal jeweils an den anderen Hochfrequenzausgang OUT1, OUT2 durchgeschaltet.

Fig. 8 zeigt ein schematisch dargestelltes Schaltbauteil 1 in einer Draufsicht entsprechend einem vierten Beispiel. Das vierte Beispiel weist ein quadratisches zweiteiliges Gehäuse 2 auf. Das in der Darstellung von oben betrachtete zweite Gehäuseteil 8 besteht vollständig aus einem lichtdurchlässig ausgebildeten Kunststoff, kann aber auch beispielsweise aus Glas bestehen.

Fig. 9 zeigt das schematisch dargestellte vierte Beispiel in einer Ansicht von unten. Das in der Darstellung von unten betrachtete erste Gehäuseteil 7, welches das Gehäuseunterteil 7 bildet, weist auf allen vier Seiten gleichmäßig verteilte Pins 9 auf. Die in der Mitte der Pins 9 liegende quadratische Fläche ist beispielsweise aus einem lichtundurchlässigen keramischen und/oder einem metallischen Werkstoff gefertigt. Das elektronische Schaltbauteil 1 eignet sich zur Montage in SMD-Technik.

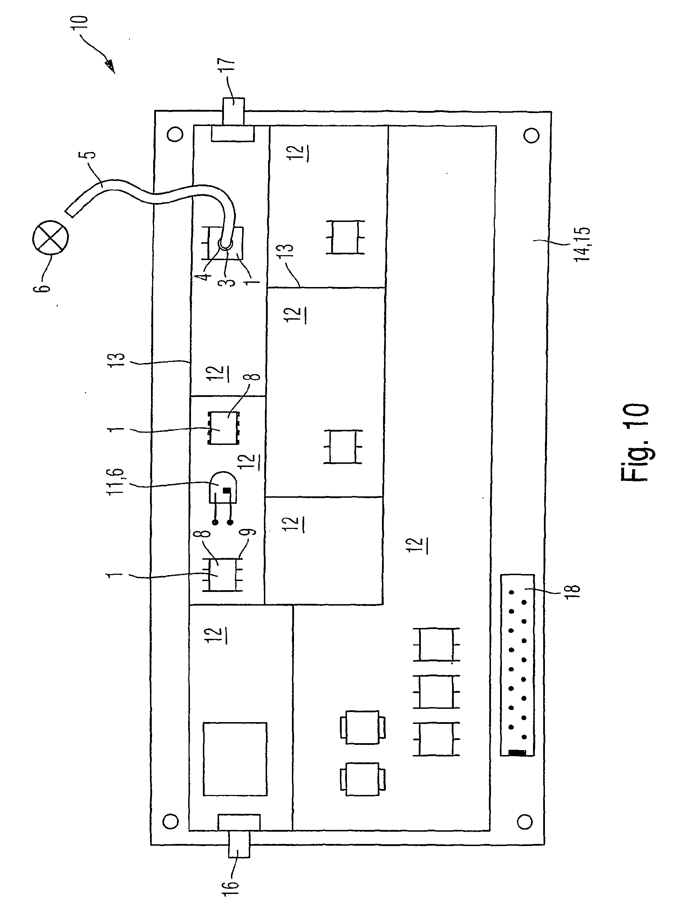

Fig. 10 zeigt den schematisch dargestellten Aufbau einer Mikrowellen-Schaltung 10 der Erfindung. Die Mikrowellen-Schaltung 10 weist einen als Leiterplatte 15 ausgebildeten Träger 14 und mehrere nach außen lichtdichte Gehäusekammern 12, die auf dem Träger 14 befestigt sind, auf. Die Gehäusekammern 12 dienen insbesondere der Abschirmung hochfrequenter elektromagnetischer Strahlung. Im gezeigten Beispiel sind in einigen der zwischen einem Hochfrequenzeingang 16 und einem Hochfrequenzausgang 17 angeordneten Gehäusekammern 12 die beleuchtbaren elektronischen Schaltbauteile 1 auf der Leiterplatte 15 montiert, vorzugsweise in SMD-Bauweise. Im gezeigten Beispiel sind in einer der Gehäusekammern 12 zwei Schaltbauteile 1 und eine Lichtquelle 6 angeordnet. Die Lichtquelle 6 ist in Form einer Leuchtdiode (LED) 11 ausgeführt, welche ebenfalls in SMD-Bauweise ausgeführt sein kann und etwa in der Mitte zwischen den beiden Schaltbauteilen 1 angeordnet ist. Die LED 11 kann somit zwei Schaltbauteile 1 gleichzeitig beleuchten. Um möglichst viel Licht in die lichtdurchlässigen Abschnitte 3 der Schaltbauteile 1 zu lenken, sind die Wandungen 13 der Gehäusekammern 12 stark lichtreflektierend ausgebildet. Im gezeigten Ausführungsbeispiel bestehen die Wandungen 13 aus poliertem Metall, insbesondere Blech. In der durch die LED 11 beleuchteten Gehäusekammer 12 sind beide Schaltbauteile 1 entsprechend dem Beispiel aus Fig. 1 und Fig. 2 ausgebildet und weisen somit jeweils ein zweites Gehäuseteil 8 auf, das vollständig aus einem transparenten Material besteht.

In der am Hochfrequenzausgang 17 liegenden Gehäusekammer 12 ist entsprechend einer alternativen Ausgestaltung ein einzelnes Schaltbauteil 1 angeordnet, das eine Aufnahmevorrichtung 4 für ein Ende eines Lichtwellenleiters 5 aufweist. Der Lichtwellenleiter 5 ist lichtdicht durch die Wandung 13 der am Hochfrequenzausgang 17 liegenden Gehäusekammer 12 geführt und ebenso lichtdicht in die Aufnahmevorrichtung 4 geführt. Da das am Hochfrequenzausgang 17 liegenden betreffende elektronische Schaltbauteil 1 in der Gehäusekammer 12 wie das in Fig. 4 ausgeführte Schaltbauteil 1 ausgebildet ist, dringt ausschließlich das durch den Lichtwellenleiter 5 geleitete Licht durch den lichtdurchlässigen Abschnitt 3 des Schaltbauteils 1. Die den Lichtwellenleiter 5 mit Licht speisende zumindest eine Lichtquelle 6 ist außerhalb der am Hochfrequenzausgang 17 liegenden Gehäusekammer 12 angeordnet, kann auf dem Träger 14 montiert sein und beispielsweise durch eine LED, ein Xenon- Halogen, - und/oder eine Gasentladungsleuchtmittel gebildet sein.

In anderen Beispielen kann ein Ende des in die Gehäusekammer 12 geführten Lichtwellenleiters 5 auch mehrere Schaltbauteile 1 beleuchten.

Der Wellenlängenbereich der Lichtquelle 6 bzw. der LED 11 ist nicht auf den sichtbaren Bereich beschränkt und umfaßt insbesondere die ultravioletten und infraroten Wellenlängenbereiche bzw. Farbbereiche oder Teile davon. Die Lichtquelle 6 kann insbesondere Licht der Farben Rot, Grün, Blau, Weiß und Orange emittieren, wobei insbesondere bei der Verwendung von LED 11 Kombinationen der genannten Farben bzw. Wellenlängenbereichen durch nur eine oder mehrere LED 11 möglich sind.

Die Lichtquelle 6 kann mit den jeweils diesen zugeordneten elektronischen Schaltbauteilen 1 auf dem gleichen Träger 14 angeordnet sein oder beispielsweise auf einem nicht dargestellten die Gehäusekammern 12 oben verschließenden Gehäusedeckel angeordnet sein. Genauso kann der Lichtwellenleiter 5 durch diesen nicht dargestellten Gehäusedeckel greifen.

Die Mikrowellen-Schaltung ist in der Form einer Dämpfungsschaltung ausgeführt. Ein am Hochfrequenzeingang 16 anliegendes Signal wird dabei mit verschiedenen Dämpfungen auf den Hochfrequenzausgang 17 durchgeschaltet, wobei über einen Steueranschluß 18 die Dämpfungswerte eingestellt und ggf. die Lichtquellen 6 angesteuert werden.

In weiteren nicht dargestellten Beispielen können sowohl das Gehäuseoberteil 8 und das Gehäuseunterteil 7 lichtdurchlässig ausgebildet sein und/oder das Gehäuse 2 kann einteilig vollständig lichtdurchlässig ausgebildet sein.

## Patentansprüche

1. Elektronisches Schaltbauteil (1) mit Feldeffekt-Transistoren auf Galium-Arsenid-Basis und mit einem eigenem Gehäuse (2), welches wenigstens einen lichtdurchlässigen Abschnitt (3) aufweist,
**dadurch gekennzeichnet,**
**dass** das Gehäuse (2) zumindest eine Aufnahmevorrichtung (4) für ein Ende eines Lichtwellenleiters (5) und/oder eine Lichtquelle (6) aufweist, und
**dass** die Aufnahmevorrichtung mit dem Gehäuse (2) einstückig ausgeführt ist.

2. Elektronisches Schaltbauteil nach Anspruch 1,
**dadurch gekennzeichnet,**
**dass** die Feldeffekt-Transistoren GaAs-MESFET sind.

3. Elektronisches Schaltbauteil nach Anspruch 1,
**dadurch gekennzeichnet,**
**dass** die zumindest eine Aufnahmevorrichtung (4) so ausgebildet ist, dass ausschließlich das Licht aus der in der Aufnahmevorrichtung (4) aufgenommenen Lichtquelle (6) und/oder aus dem in der Aufnahmevorrichtung (4) aufgenommen Ende des Lichtwellenleiters (5) durch den lichtdurchlässigen Abschnitt (3) auf die Feldeffekt-Transistoren fällt.

4. Elektronisches Schaltbauteil nach einem der vorangegangenen Ansprüche,
**dadurch gekennzeichnet,**
**dass** das elektronische Schaltbauteil (1) als SMD-Bauelement ausgebildet ist.

5. Elektronisches Schaltbauteil nach einem der vorangegangenen Ansprüche,
**dadurch gekennzeichnet,**
**dass** der lichtdurchlässige Abschnitt (3) aus einem lichtdurchlässigen Material besteht.

6. Elektronisches Schaltbauteil nach Anspruch 5,
**dadurch gekennzeichnet,**
**dass** das lichtdurchlässige Material, insbesondere durch seine Formgebung, das Licht auf die Feldeffekt-Transistoren umlenkt und/oder auf die Feldeffekt-Transistoren konzentriert.

7. Elektronisches Schaltbauteil nach Anspruch 5 oder 6,
**dadurch gekennzeichnet,**
**dass** das lichtdurchlässige Material zumindest teilweise aus Glas besteht.

8. Elektronisches Schaltbauteil nach einem der Ansprüche 5 bis 7,
**dadurch gekennzeichnet,**
**dass** das lichtdurchlässige Material zumindest teilweise aus zumindest einem Kunststoff, insbesondere aus lichtdurchlässigem Silicon (SI), Polyamid (PA), Polycarbonat (PC), Polyester, Polyvinylacetat (PVAC), Polyethylen (PE), Polypropylen (PP), Polyvinylchlorid (PVC), Polymethylmethacrylat (PMMA), Acrylglas und/oder Polystyrol (PS) besteht.

9. Elektronisches Schaltbauteil nach einem der vorangegangenen Ansprüche,
**dadurch gekennzeichnet,**
**dass** das Gehäuse (2) zumindest zweiteilig mit zumindest einem ersten Gehäuseteil (7) und einem zweiten Gehäuseteil (8) ausgeführt ist.

10. Elektronisches Schaltbauteil nach Anspruch 9,
**dadurch gekennzeichnet,**
**dass** das erste Gehäuseteil (7) ein Gehäuseunterteil (7) bildet, welches zu einem Träger (14, 15) weist, auf dem das elektronische Schaltbauteil (1) befestigt ist, und das zweite Gehäuseteil (8) ein Gehäuseoberteil (8) bildet, welches dem Gehäuseunterteil (7) gegenüberliegt.

11. Elektronisches Schaltbauteil nach Anspruch 9 oder 10,
**dadurch gekennzeichnet,**
**dass** das ganze zweite Gehäuseteil (8) lichtdurchlässig ist.

12. Elektronisches Schaltbauteil nach einem der Ansprüche 9 bis 11,
**dadurch gekennzeichnet,**
**dass** das erste Gehäuseteil (7) lichtundurchlässig ist und wenigsten teilweise aus einem keramischen Material besteht.

13. Elektronisches Schaltbauteil nach einem der Ansprüche 9 bis 12,
**dadurch gekennzeichnet,**
**dass** das erste Gehäuseteil (7) lichtundurchlässig ist und wenigsten teilweise aus einem metallischen Material besteht.

## Claims

1. Electronic-switching component (1) with gallium-arsenide-based field-effect transistors, with a dedicated housing (2), which provides at least one transparent portion (3),
**characterised in that**
the housing (2) provides at least one retaining device (4) for one end of an optical waveguide (5) and/or a light source (6), and
that the retaining device is designed in one piece with the housing (2).

2. Electronic-switching component according to claim 1,
**characterised in that**
the field-effect transistors are GaAs-MESFETs.

3. Electronic-switching component according to claim 1,
**characterised in that**
the at least one retaining device (4) is designed in such a manner that exclusively the light from the light source (6) accommodated in the retaining device (4) and/or from the end of the optical waveguide (5) accommodated in the retaining device (4) passes through the transparent portion (3) onto the field-effect transistors.

4. Electronic-switching component according to any one of the preceding claims,
**characterised in that**
the electronic-switching component (1) is designed as a surface-mounted component (SMD).

5. Electronic-switching component according to any one of the preceding claims,
**characterised in that**
the transparent portion (3) consists of a transparent material.

6. Electronic-switching component according to claim 5,
**characterised in that**,
especially through its shape, the transparent material deflects the light onto the field-effect transistors and/or concentrates the light onto the field-effect transistors.

7. Electronic-switching component according to claim 5 or 6,
**characterised in that**
the transparent material consists at least partially of glass.

8. Electronic-switching component according to any one of claims 5 to 7,
**characterised in that**
the transparent material consists at least partially of at least one synthetic material, in particular, transparent silicon (SI), polyamide (PA), polycarbonate (PC), polyester, polyvinylacetate (PVAC), polyethylene (PE), polypropylene (PP), polyvinylchloride (PVC), polymethylmethacrylate (PMMA), acrylic glass and/or polystyrene (PS).

9. Electronic-switching component according to any one of the preceding claims,
**characterised in that**
the housing (2) is designed in at least two parts with at least one first housing component (7) and a second housing component (8).

10. Electronic-switching component according to claim 9,
**characterised in that**
the first housing component (7) forms a lower housing component (7), which faces towards a carrier (14, 15), to which the electronic-switching component (1) is attached, and that the second housing component (8) forms an upper housing component (8), which is disposed opposite to the lower housing component (7).

11. Electronic-switching component according to claim 9 or 10,
**characterised in that**
the entire second housing component (8) is transparent.

12. Electronic-switching component according to any one of claims 9 to 11,
**characterised in that**
the first housing component (7) is opaque and consists at least partially of a ceramic material.

13. Electronic-switching component according to any one of claims 9 to 12,
**characterised in that**
the first housing component (7) is opaque and consists at least partially of a metallic material.

## Revendications

1. Composant de commutation (1) électronique avec des transistors à effet de champ sur une base gallium-arséniure et avec un boîtier propre (2), lequel comporte au moins une section (3) transparente,
**caractérisé en ce que**
le boîtier (2) comporte au moins un dispositif de réception (4) pour une extrémité d'un câble à fibres optiques (5) et/ou une source de lumière (6) et
le dispositif de réception est réalisé d'une seule pièce avec le boîtier (2).

2. Composant de commutation électronique selon la revendication 1, **caractérisé en ce que** les transistors à effet de champ sont des transistors GaAs-MESFET.

3. Composant de commutation électronique selon la revendication 1, **caractérisé en ce qu'**au moins un dispositif de réception (4) est conçu de sorte que la lumière provenant exclusivement de la source de lumière (6) reçue dans le dispositif de réception (4) et/ou provenant de l'extrémité du câble à fibre optique (5) reçue dans le dispositif de réception (4) tombe sur les transistors à effet de champ par la section (3) transparente.

4. Composant de commutation électronique selon l'une quelconque des revendications précédentes, **caractérisé en ce que** le composant de commutation électronique (1) est conçu comme élément SMD.

5. Composant de commutation électronique selon l'une quelconque des revendications précédentes, **caractérisé en ce que** la section transparente (3) se compose d'un matériau transparent.

6. Composant de commutation électronique selon la revendication 5, **caractérisé en ce que** le matériau transparent, plus particulièrement par sa forme, dévie la lumière sur les transistors à effet de champ et/ou se concentre sur les transistors à effet de champ.

7. Composant de commutation électronique selon la revendication 5 ou 6, **caractérisé en ce que** le matériau transparent se compose au moins en partie de verre.

8. Composant de commutation électronique selon l'une quelconque des revendications 5 à 7, **caractérisé en ce que** le matériau transparent se compose au moins en partie d'un plastique, plus particulièrement de silicone transparent (SI), de polyamide (PA), de polycarbonate (PC), de polyester, d'acétate de polyvinyle (PVAC), de polyéthylène (PE), de polypropylène (PP), de polychlorure de vinyle (PVC), de méthacrylate de polyméthyle (PMMA), de plexiglas et/ou de polystyrène (PS).

9. Composant de commutation électronique selon l'une quelconque des revendications précédentes, **caractérisé en ce que** le boîtier (2) est réalisé au moins en deux parties avec au moins une première partie de boîtier (7) et une seconde partie de boîtier (8).

10. Composant de commutation électronique selon la revendication 9, **caractérisé en ce que** la première partie du boîtier (7) forme une partie inférieure de boîtier (7), laquelle est placée sur un support (14, 15), sur lequel le composant de commutation électronique (1) est fixé, et la seconde partie de boîtier (8) forme une partie supérieure de boîtier (8), laquelle est opposée à la partie inférieure de boîtier (7).

11. Composant de commutation électronique selon la revendication 9 ou 10, **caractérisé en ce que** toute la seconde partie de boîtier (8) est transparente.

12. Composant de commutation électronique selon l'une quelconque des revendications 9 à 11, **caractérisé en ce que** la première partie de boîtier (7) n'est pas transparente et se compose au moins en partie d'un matériau céramique.

13. Composant de commutation électronique selon l'une quelconque des revendications 9 à 12, **caractérisé en ce que** la première partie de boîtier (7) n'est pas transparente et se compose au moins en partie d'un matériau métallique.
